# EUROPEAN PATENT APPLICATION

(11) **EP 1 650 687 A1**
(43) Date of publication of application: **26.04.2006**
(21) Application number: 05109418.3
(22) Date of filing: 11.10.2005
(51) Int. Cl.: G06F 17/50

(54) **Method and apparatus to access modeled memory in a hardware emulator**

(30) Priority: 21.10.2004 US 970409
(71) Applicant: International Business Machines Corporation, Armonk, N.Y. 10504 (US)
(72) Inventor: Gooding, Thomas, Michael, Winchester, Hampshire SO21 2JN (GB); Musselman, Roy, Glenn, Winchester, Hampshire SO21 2JN (GB)
(74) Representative: Waldner, Philip

(57) **Abstract**

The present invention enhances the Direct Access Stimulus (DAS) interface presently employed within a logic simulation hardware emulator to provide efficient random access to all logic arrays present within a logic model while the emulator is actively cycling. The present invention achieves this by introducing a set of special DAS array port logic within the logic model. This new port logic interfaces with a set of connections on the DAS card interface and provides the control program with efficient random accessibility to all arrays within the design under test (i.e., the logic model).

## Description

### Field of the Invention

The present invention relates generally to logic simulation hardware emulation, and more specifically to the efficient access of modeled memory in a logic simulation hardware emulator.

### Background of the Invention

Design verification is essential to virtually any very large scale integration (VLSI) design project. One of the popular verification methods is logic simulation. Logic simulation software reports on how a circuit under design responds to a sequence of input vectors, so the designer can judge whether the circuit behaves as expected over an input sequence. The more vectors simulated, the greater confidence the designer has in the correctness of the designing circuit.

As circuit complexity increases and the time to market shortens, inadequate simulation speed becomes a major bottleneck in the design process. As a result, several special purpose machines have been built to simulate/emulate complex logic designs in hardware, rather than software. Such emulation/acceleration devices can provide several orders of magnitude of speed improvement during the simulation/emulation process. Thus, the necessity and usefulness of such devices has increased enormously with growth in the complexity of integrated circuits.

An emulation/acceleration engine operates to mimic the logical design of a set of one or more integrated circuit chips. The emulation of these chips in terms of their logical design is highly desirable for several reasons which are discussed in more detail below. It is, however, noted that the utilization of emulation/acceleration engines has also grown up with and around the corresponding utilization of design automation tools for the construction and design of integrated circuit chip devices. In particular, as part of the input for the design automation process, logic descriptions of the desired circuit chip functions are provided. The existence of such software tools for processing these descriptions in the design process is well mated to the utilization of emulation/acceleration engines which are electrically configured to duplicate the same logic function that is provided in a design automation tool.

Utilization of emulation/acceleration devices permits testing and verification, via actual electrical circuits, of logical designs before these designs are committed to a so-called "silicon foundry" for manufacture. The input to such foundries is the functional logic description required for the chip, and its output is initially a set of photolithographic masks which are then used in the manufacture of the desired electrical circuit chip devices. However, it is noted that the construction of such masks and the initial production of circuit chips is expensive. Any passage of a given device having the prescribed logic functionality though such a foundry is an expensive and time consuming process which clearly should be undertaken only once. It is the purpose of emulation/acceleration engines to ensure such a single passage from the functional logic design stage through the stage of chip production via such a foundry.

Verifying that logic designs are correct before committing a design to manufacturing, therefore, eliminates the need for costly and time-consuming multiple passes through a silicon foundry. Debugging logic errors deep inside a logic chip can be extremely difficult because of very limited observability. Emulation provides two very significant advantages. Firstly, the proper verification of a functional logic design eliminates the need for a second costly passage through the foundry, and, secondly, and just as importantly, getting the design "right the first time" means that the design does not have to be corrected in the foundry. Accordingly, production delays are significantly reduced and the time to market for the particular technology/technology improvements embedded in the integrated circuit chip is greatly reduced, thus positively impacting the ability to deliver the most sophisticated technological solutions to consumers in as short of time as possible.

An additional advantage that emulation/acceleration systems have is that they act as a functioning system of electrical circuits which makes possible the early validation of software which is meant to operate the system that the emulator/accelerator is mimicking. Thus, software can be designed, evaluated and tested well before the time when the system is embodied in actual circuit chips. Additionally, emulation/acceleration systems can also operate as simulator-accelerator devices thus providing a high speed simulation platform.

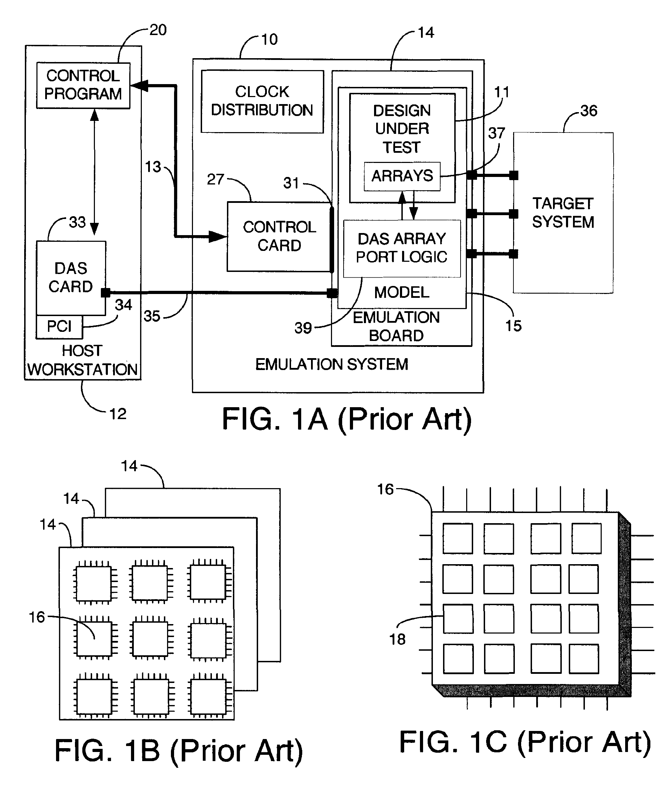

**Figure 1A** illustrates a high-level block diagram of a typical emulation/acceleration system 10 (hereinafter referred to as emulation system 10), which is controlled by a host workstation 12. Emulation system 10 includes at least one emulation board 14, which, in turn, contains a plurality of emulation modules 16, as shown in **Fig. 1B.** Each emulation module 16 contains a plurality of emulation processors 18, as shown in **Fig. 1C.** Each emulation processor 18 is programmed to evaluate a particular logic function (for example, AND, OR, XOR, NOT, NOR, NAND, etc.). The programmed emulation processors 18, together as a connected unit, emulate an entire desired logic design under test 11 (i.e., the programmed emulation processors form part of a simulation "model" 15 for the logic design). This simulation model 15 may also include some additional controllability/observability logic (e.g., DAS Array Port Logic 39) to aid in the simulation/emulation process.

The overall simulation throughput of such a system is controlled (and limited) by the interface between the simulation model 15 running on the emulation system 10 and a runtime control program 20 running on a host workstation 12. Transactions between the runtime control program 20 and the simulation model 15 include reading and writing the values of logic facilities contained within the model and the execution of cycles to recalculate the model state. The default mechanism for these access transactions is through the emulator service interface which consists of a network connection 13 between the host workstation 12 and custom control cards 27 resident within the emulation system 10. The control cards then interface with the emulation logic boards through a custom maintenance interface 31. The maintenance interface 31 has access to all logic and memory elements within the emulation board 14. Although the maintenance interface 31 has a relatively low latency, the latency of the network connection 13 is rather high (e.g., 1-2 ms). Multiplied against several hundreds of thousands of operations, that 1-2 ms latency greatly impacts the overall simulation performance.

Further, if the emulator is cycling, the maintenance interface 31 has a further restriction in that accesses can only be performed within a narrow timing window, such that only a handful of accesses per cycle is possible. This significantly reduces the memory access bandwidth available via the maintenance interface 31.

An alternate communication path may also be provided between the runtime control program 20 and the simulation model 15 that bypasses the network connection 13 and control subsystem. This path comprises a custom Direct Access Stimulus (DAS) card 33 plugged into a PCI slot 34 in the host workstation 12. A special high-speed multi-strand DAS cable 35 is connected between the DAS card 33 and the emulation board(s) 14 that contain the logic model 15.

This interface is much more efficient than the network interface 13 because of the more direct connection to logic facilities. To use this interface most efficiently, a single "cycle forever" command is issued from the control program 20 to the emulator control subsystem through the network interface 13. The emulation system 10 will then continuously evaluate the model state. This mode of operation is usually required when the emulator is physically connected to an external target system that requires uninterrupted operation on the interface to the emulator. Read and write accesses from the control program 20 through the DAS card interface will then directly access the model facilities as they are being evaluated. These accesses will not incur the long latencies associated with the commands sent through the control network.

Within the context of system verification, it is not uncommon to develop a simulation testcase scenario that involves a significant amount of reoccurring memory data transfers between the control program 20 and the logical arrays 37 within the model. These scenarios occur in such systems comprised of microprocessors or digital signal processors (DSPs). Efficient random access to logic arrays 37 can be critical to the performance of the simulation. In this scenario, the network accesses (and the cumulative latencies of the accesses) dominate the performance bottleneck.

Also the model facilities available via the DAS card interface are limited to a subset of logic signals that can be routed between the entire emulation system and the DAS interface. Therefore, directly connecting a large number of array interface signals to the DAS interface is impractical.

There is a need to access the DAS interface in an innovative fashion to provide efficient random access to all logic arrays within an emulation model while the emulator is actively cycling.

### Summary of the Invention

The present invention provides a method, apparatus and computer program product to efficiently access all logic arrays within a logic model while the logic simulation hardware emulator is actively cycling. To accomplish this, the present invention creates special DAS port array logic within the logic model during logic synthesis, then adds additional run-time software routines within the control program to directly access the logic model via the special DAS array port logic at run-time.

In one embodiment, the present invention describes a method for providing direct random access to a plurality of logic arrays within a logic simulation model residing on a logic simulation hardware emulator. The method begins by synthesizing a set of Direct Access Stimulus (DAS) port array logic coupled to the plurality of logic arrays. Next, the method enables a control program to randomly access the plurality of logic arrays during run-time via a Direct Access Stimulus (DAS) interface coupling the control program to the set of DAS array port logic.

In one embodiment, the step of synthesizing the set of DAS port array logic includes the steps of: 1) creating additional read and write ports on each of the plurality of logic arrays; and 2) creating a plurality of new signals that are connected to the DAS interface.

In one embodiment, the step of enabling the control program to randomly access the plurality of logic arrays for read access includes the steps of: 1) selecting the same row in each of the plurality of logic arrays via an address select signal generated at the control program; 2) selecting one of the plurality of logic arrays via an array signal generated at the control program; and 3) returning the selected row from the selected logic array to the control program via a data output signal.

In one embodiment, the step of enabling the control program to randomly access the plurality of logic arrays for write access includes the steps of: 1) selecting the same row in each of the plurality of logic arrays via an address select signal generated at the control program; 2) selecting one of the plurality of logic arrays via an array select signal generated at the control program; 3) placing a value on a data input signal to write at the selected row of the selected logic array; and 4) writing the value on the data input signal to the selected row of the selected logic array upon activation of an array write signal generated at the control program.

The present invention also provides a logic simulation hardware emulation apparatus, which includes a host workstation having a control program. The apparatus further includes an emulation system having a logic model, where the logic model includes a plurality of logic arrays coupled to a set of DAS array port logic. The apparatus further includes a Direct Access Stimulus (DAS) interface coupling the control program to the set of DAS array port logic. The control program randomly accesses the plurality of logic arrays within the logic model while the emulation system in actively cycling.

The DAS interface includes signals which indicate which of the plurality of logic arrays to access, along with address signal paths and data signal paths which are reused when accessing a selected logic array. In one embodiment, serializer/deserializer (SER/DES) logic components are introduced into the address and signal data paths. In one embodiment, the address and signal data paths are combined into a single global signal, wherein the global signal is alternately shifted to add/remove the address and data portions. Each of the plurality of logic arrays includes at least one new read port and at least one new write port to support the random access by the control program while the emulation system is actively cycling. The new read and write ports are selected for access by a decode of the array select signals from the DAS interface.

### Brief Description of the Drawings

**Figure 1A (Prior Art)** is a high-level block diagram of a typical logic emulation system controlled by a host workstation.
**Figure 1B (Prior Art)** is a representation of an emulation board from the logic emulation system of Figure 1A where the emulation board contains a plurality of emulation modules.
**Figure 1C (Prior Art)** is a close-up view of an emulation module, previously illustrated in Figure 1B, wherein the emulation module contains a plurality of emulation processors.
**Figure 2** illustrates a first embodiment of DAS array port logic incorporated within a logic model in accordance with the present invention.
**Figure 3** illustrates a second embodiment of DAS array port logic incorporated within a logic model, wherein special serializer/deserializer (SER/DES) logic components are inserted into the address and signal paths.
**Figure 4** illustrates a method for providing direct random access to a plurality of logic arrays within a logic simulation model residing on a logic simulation hardware emulator in accordance with the present invention.
**Figure 5** illustrates a computer system suitable for use with the embodiments illustrated in Figures 2-4.

### Detailed Description of the Preferred Embodiments

The present invention enhances the Direct Access Stimulus (DAS) interface presently employed within a logic simulation hardware emulator to provide efficient random access to all logic arrays present within a logic model while the emulator is actively cycling. The present invention achieves this by introducing a set of special DAS array port logic within the logic model. This new port logic interfaces with a set of connections on the DAS card interface and provides the control program with efficient random accessibility to all arrays within the design under test (i.e., the logic model).

The new signals on the DAS card select which array to access and provide a single set of address and data lines that are reused when accessing each logical array individually. New read and write ports are added to each logical array that is desired to be accessed in this fashion. The specific ports are selected by a decode of the array select signals from the DAS interface.

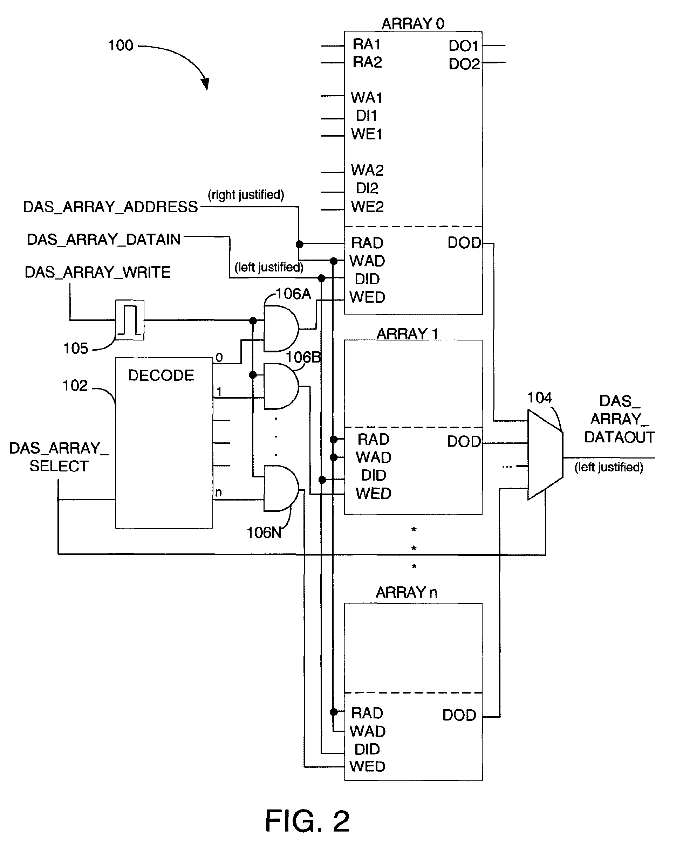

Turning now to the Drawings, wherein like numbers denote like parts throughout the several views, **Figure 2** illustrates one embodiment of DAS array port logic within a logic model in accordance with the present invention, shown generally at 100. In a logic model array data is accessed via port logic surrounding the logical array memory elements (e.g., ARRAY0...ARRAYn). Read ports consist of read address input signals (e.g., RA1, RA2) whose value identifies and selects a row within the logical array. The data contained within the selected array row is propagated to the data-out output signals (e.g., DO1 DO2).

Write ports consist of write address input signals (e.g., WA1, WA2) which also select an array row. When a write enable signal (e.g., WE1, WE2) is active, the values on the data-in signals (e.g., DI1, DI2) replace the values contained within the selected array row. The number of signal strands contained within each signal bundle is consistent with the dimensions of the associated array. There can be multiple read and write ports for each array in the array model.

As illustrated in **Figure 2**, Array0 has two normal read ports and two normal write ports. The normal read and write ports are not shown on the other arrays. To implement the present invention, new logic synthesis routines are run during the model build process which attach one additional read port and one additional write port to each array that is to be accessed using this method. As illustrated, the signals associated with these new "DAS" ports have a "D" appended as a suffix (e.g., RAD, DOD, etc.). Each individual array is assigned a unique identifier.

New signals are created and connected to the DAS interface. These new signals are identified in **Figure 2** as having a "DAS_ARRAY" prefix. The DAS_ARRAY_DATAOUT signals originate from the DAS array port logic and are sent back to the control program 20 via the DAS cable 35. All the values on the other DAS_ARRAY signals originate from the control program 20. These signals are inputs to the DAS array port logic. The DAS_ARRAY_ADDRESS and DAS_ARRAY_DATAIN signals are shared by (or fan-out to) all of the DAS ports within the logic model. The RAD and WAD port signals are both connected to the DAS_ARRAY_ADDRESS. The assigned ID values on the DAS_ARRAY_SELECT signals identify the selected logic array.

Only one row within one logic array is either read or written at a time per instance of the DAS array port logic. During a read access, DAS_ARRAY_ADDRESS selects the same row in all arrays and the DAS_ARRAY_SELECT chooses one of the DAS port DOD signals to propagate to DAS_ARRAY_DATAOUT via a multiplexer 104. During a write access, DAS_ARRAY_ADDRESS again selects the row. DAS_ARRAY_DATAIN is sent to all DAS port DID inputs. DAS_ARRAY_SELECT is decoded by decoder 102 to activate only one decode output that corresponds to the selected array. A transition on DAS_ARRAY_WRITE (via edge detector 105) produces a pulse on the appropriate DAS port WED input (via AND gates 106A...106N) which causes the replacement of the data in the appropriate array and row.

Since logic arrays within a logic model can have various dimensions, the number of strands in the DAS signal bundles must be sufficient to handle the maximum required. Thus, some strands will be unutilized on smaller arrays. Since it is convenient for control program 20 routines to use integers to address memory, the illustrative example shows the preferred implementation on a big-endian workstation so that the address signals are right justified within the DAS_ARRAY_ADDRESS bundle to line up with the integers. The various (possibly large) data widths would generally be more easily handled if the data was left justified within the DAS_ARRAY_DATAIN bundle.

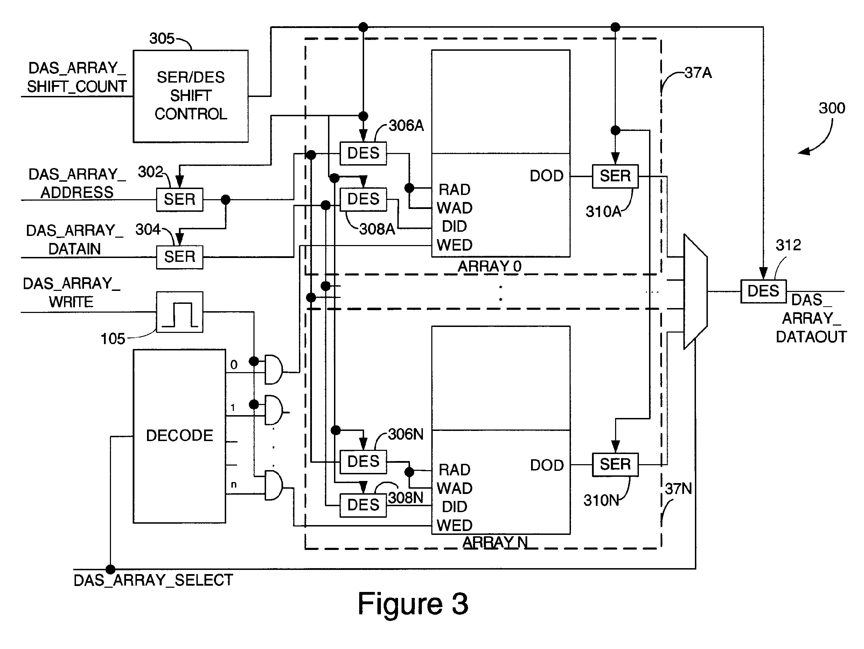

For large models with a large number of arrays (e.g., thousands), the fanout and routing of the address and data signals can be a limiting factor in the success of model build. This fan-out can be reduced at the expense of performance by introducing special serializer/deserializer (SER/DES) logic components in the address and signal paths, as illustrated in **Figure 3**, shown generally at 300. These SER/DES components convert a wide parallel signal path to a narrow serial path and then back to the wide parallel format. The number of signals with high fan-out can now be reduced to one signal for the address (e.g., DAS_ARRAY_ADDRESS) and one signal for data-in (e.g., DAS_ARRAY_DATAIN). Also, the amount of logic required to implement the data-out selector is significantly reduced.

In the illustrated example, both DAS_ARRAY_ADDRESS and DAS_ARRAY_DATAIN signals are serialized by serializers 302 and 304 prior to entering the logic arrays 37A-37N. Signal DAS_ARRAY_SHIFT_COUNT provides a SER/DES shift control module 305 with a shift count for the serialization operation, which is subsequently provided to serializers 302 and 304. After the serialized data reaches the logic arrays 37A-37N, the serialized address and data information is de-serialized by de-serializers 306A-306N and 308A-308N. Signal DAS_ARRAY_SHIFT_COUNT further provides SER/DES shift control module 305 with a shift count for the de-serialization operation, which is subsequently provided to de-serializers 306A-306N and 308A-308N. Data leaving the logic arrays 37A-37N (e.g., via DOD) is also serialized prior to leaving the logic array by serializers 310A-310N. Once again, signal DAS_ARRAY_SHIFT_COUNT provides SER/DES shift control module 305 with a shift count for the serialization of the data output, which is subsequently provided to serializers 310A-310N. After the serialized data leaves the logic array 37A-37N, it is once again de-serialized by de-serializer 312, and the resultant de-serialized DAS_ARRAY_DATAOUT signal is returned to the control program 20. Signal DAS_ARRAY_SHIFT_COUNT provides SER-DES shift control module 305 with a shift count for the de-serialization of the signal at de-serializer 312.

The logic contained within the SER/DES shift control function is similar to the burst clock logic employed within co-pending patent application no. 10/422,189, filed April 29, 2003, entitled "Method and Apparatus to Use Clock Bursting to Minimize Command Latency in a Logic Simulation Hardware Emulator/Accelerator", hereby incorporated by reference.

One drawback to the implementation of **Figure 3** is that read or write operations will now take several more emulator cycles to execute (i.e., one cycle for every bit that is shifted through the SER/DES components. While this mode may not, in some instances, provide optimum performance, it is still much more efficient than any other previous alternatives.

In an alternative embodiment to the SER/DES example shown in **Figure 3**, the DAS_ARRAY_ADDRESS and DAS_ARRAY_DATAIN signals may be combined into a single global signal, wherein the SER/DES logic would shift one, and then the other value. This embodiment provides an even greater improvement in the number of signals required within the array port logic.

In yet another embodiment (not illustrated), DES functions may be shared between multiple arrays with the same dimensions, since the DES logic is identical. In the illustrated embodiment, the distinction between array accesses is contained within the unique write enable (WE) signals and the global DAS_ARRAY_SELECT signals.

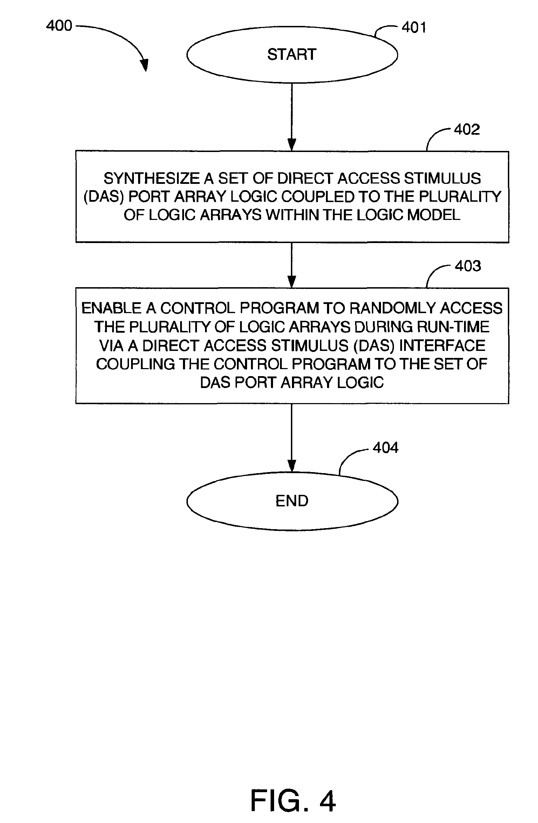

**Figure 4** illustrates a method for providing direct random access to a plurality of logic arrays within a logic simulation model residing on a logic simulation hardware emulator, shown generally at 400. At block 401, the method begins. At block 402, the method synthesizes a set of Direct Access Stimulus (DAS) port array logic coupled to the plurality of logic arrays within the logic model. In order to accomplish this step, the method: 1) creates additional read and write ports on each of the plurality of logic arrays; and 2) creates a plurality of new signals that are connected to the DAS interface to enable direct access to the newly created read and write ports.

At block 403, the method enables a control program (residing on the host workstation) to randomly access the plurality of logic arrays during run-time via a Direct Access Stimulus (DAS) interface coupling the control program to the set of DAS array port logic.

For read access, the present invention selects the same row in each of the plurality of logic arrays via an address select signal generated at the control program. Next, one of the plurality of logic arrays is selected via an array select signal generated at the control program. Finally, the selected row from the selected logic array is returned to the control program via a data output signal. For write access, the present invention selects the same row in each of the plurality of logic arrays via an address select signal generated at the control program. Next, one of the plurality of logic arrays is selected via an array select signal generated at the control program. Next, a value is placed on a data input signal to write at the selected row of the selected logic array. Finally, the value on the data input signal is written to the selected row of the selected logic array upon activation of an array write signal generated at the control program. The method ends at block 404.

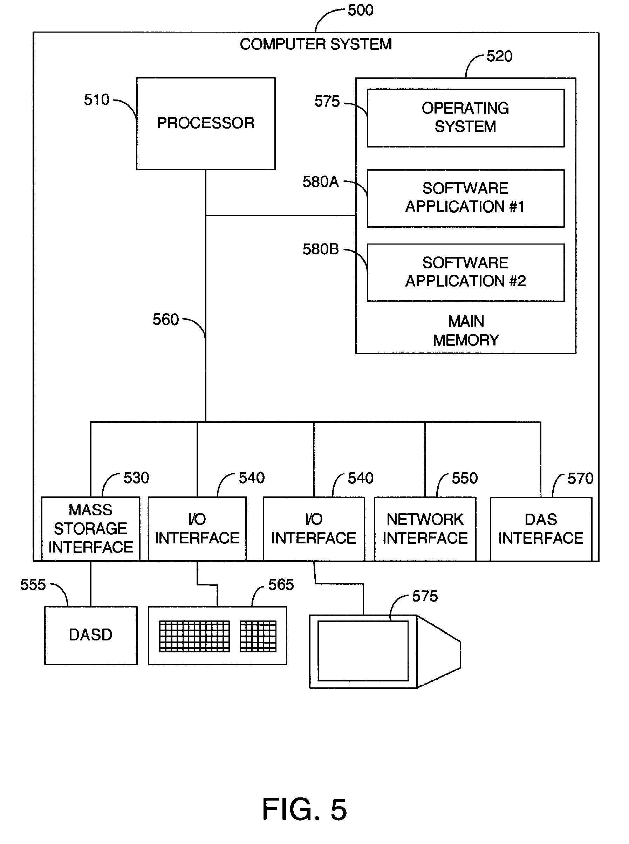

Figure 5 depicts a computer system 500 embodiment suitable for use as the host workstation (Figure 1, element 12) of the present invention. The computer system 500 includes a processor 510 connected to a main memory 520, a mass storage interface 530, one or more I/O interfaces 540, a network interface 550, and a DAS interface 570 via a system bus 560. The mass storage interface 530 connects one or more mass storage devices, such as a direct access storage device (DASD) 555, to the system bus 560. The input/output (I/O) interface 540 connects one or more input/output devices, such as a keyboard 565 or computer display 575, to the system bus 560. The network interface 550 connects the computer system 500 to other devices (not shown). The main memory 520 contains one or more programs, such as an operating system 530, and software applications 580A, 580B (e.g., logic synthesis software, or control program 20).

The processor 510 in this embodiment may be any device capable of executing the program instructions stored in the main memory 520, and may be constructed from one or more microprocessors and/or integrated circuits. Furthermore, although the computer system 500 is shown to contain only a single processor 510 and a single system bus 560, those skilled in the art will appreciate that the present invention may be practiced using a computer system that has multiple processors 510 and/or multiple buses 560. In addition, the interfaces 530, 540, 550 and 570 may each include their own separate, fully programmed microprocessors that are used to off-load compute-intensive processing from the main processor 510.

When the computer system 500 starts up, the processor 510 initially executes the program instructions that make up the operating system 520, which is a sophisticated program that manages the resources of computer system 500, including: the processors 510; the main memory 520; the mass storage interface 530; the I/O interfaces 540; the network interface 550; the DAS interface 570; and the system buses 560. Administrators may enter commands for the operating system 520 using appropriate I/O devices, such as the keyboard 565 or mouse (not shown), connected to the I/O interfaces 540.

The computer system 500 may utilize well-known virtual addressing mechanisms that allow its programs to behave as if they have access to a large, single storage entity instead of access to multiple, smaller storage entities such as main memories 520 and the DASD device 555. Therefore, while the operating system 520 and the software applications 580A, 580B and their associated data are shown to reside in main memory 520, those skilled in the art will recognize that these items are not necessarily all completely contained in main memory 520 at the same time, and may also reside in the virtual memory of other computer systems (not shown) coupled to the computer system.

One suitable computer system 500 is an eserver pSeries® computer running the AIX® multitasking operating system, both of which are produced by International Business Machines Corporation of Armonk, NY. However, those skilled in the art will appreciate that the mechanisms and apparatus of the present invention apply equally to any computer system 500 and operating system 520, regardless of whether the computer system 500 is a complicated multi-user computing apparatus; a single-use workstation; a pervasive device, such as a cellular telephone or personal digital assistant (PDA); or an embedded control system.

Although the present invention has been described in detail with reference to certain examples thereof, it may be also embodied in other specific forms without departing from the essential spirit or attributes thereof. For example, those skilled in the art will appreciate that the present invention is capable of being distributed as a program product in a variety of forms, and applies equally regardless of the particular type of signal bearing media used to actually carry out the distribution. Examples of suitable signal bearing media include, but are not limited to: (i) information permanently stored on non-writable storage media (e.g., read-only memory devices within a computer such as CD-ROM disks readable by a CD-ROM drive); (ii) alterable information stored on writable storage media (e.g., floppy disks within a diskette drive, a CD-R disk, a CD-RW disk, or hard-disk drive); or (iii) information conveyed to a computer by a communications medium, such as through a computer or telephone network, including wireless communications, and specifically includes information downloaded from the Internet and other networks. Such signal-bearing media, when carrying computer-readable instructions that direct the functions of the present invention, represent embodiments of the present invention.

The invention in its broader aspects is therefore not limited to the specific details, representative apparatus and method, and illustrative examples shown and described. Accordingly, departures may be made from such details without departing from the spirit or scope of applicants' general inventive concept. It is intended that the scope of the present invention be limited not by this detailed description, but rather by the claims appended hereto. Therefore, the invention lies in the claims hereinafter appended.

## Claims

1. A method for providing direct random access to a plurality of logic arrays within a logic simulation model residing on a logic simulation hardware emulator, the method comprising the steps of:
synthesizing a set of Direct Access Stimulus (DAS) port array logic coupled to the plurality of logic arrays; and
enabling a control program to randomly access the plurality of logic arrays during run-time via a Direct Access Stimulus (DAS) interface coupling the control program to the set of DAS port array logic.

2. The method of claim 1, wherein the step of synthesizing a set of DAS port array logic coupled to the plurality of logic arrays comprises the steps of:
creating additional read ports and write ports on each of the plurality of logic arrays; and
creating a plurality of new signals that are connected to the DAS interface.

3. The method of claim 1 or 2, wherein the step of enabling a control program to randomly access the plurality of logic arrays during run-time via a DAS interface coupling the control program to the set of DAS port array logic comprises the steps of:
for a read access, selecting the same row in each of the plurality of logic arrays via an address select signal generated at the control program;
selecting one of the plurality of logic arrays via an array select signal generated at the control program;
returning the selected row from the selected logic array to the control program via a data output signal.

4. The method of claim 1, 2 or 3, wherein the step of enabling a control program to randomly access the plurality of logic arrays during run-time via a DAS interface coupling the control program to the set of DAS port array logic comprises the steps of:
for a write access, selecting the same row in each of the plurality of logic arrays via an address select signal generated at the control program;
selecting one of the plurality of logic arrays via an array select signal generated at the control program;
placing a value on a data input signal to write at the selected row of the selected logic array; and
writing the value on the data input signal to the selected row of the selected logic array upon activation of an array write signal generated at the control program.

5. The method of claim 2, wherein the plurality of signals are serialized after the receipt of the signals by the DAS interface, and de-serialized before entering the plurality of logic arrays.

6. The method of claim 5, wherein the plurality of signals includes data signals and/or address signals.

7. A logic simulation hardware emulator, comprising:
a host workstation having a control program;
an emulation system having a logic model, the logic model comprising a plurality of logic arrays coupled to a set of Direct Access Stimulus (DAS) array port logic; and
a Direct Access Stimulus (DAS) interface coupling the control program to the set of DAS array port logic and optionally including one or more signals which indicate which of the plurality of logic arrays to access;
wherein the control program randomly accesses the plurality of logic arrays within the logic model while the emulation system is actively cycling.

8. The logic simulation hardware emulator of claim 7, wherein the DAS interface includes one or more address signal paths and data signal paths which are reused when accessing a selected logic array and optionally one or more serializer/deserializer (SER/DES) logic components are introduced in the one or more address and data signal paths.

9. The logic simulation hardware emulator of claim 11, wherein the address signal paths and data signal paths are combined into a single global signal and optionally the global signal is alternatively shifted to add/remove the address and data portions of the global signal.

10. The logic simulation hardware emulator of claim 8, wherein each of the plurality of logic arrays includes at least one new read port and at least one new write port to support the random access by the control program while the emulation system is actively cycling and optionally the at least one new read port and at least one new write port are selected for access by a decode of the array select signals from the DAS interface.

11. A computer-readable program stored on a computer readable-medium, the computer-readable program providing a method for providing direct random access to a plurality of logic arrays within a logic simulation model residing on a logic simulation hardware emulator, the computer-readable program comprising the steps of:
synthesizing a set of Direct Access Stimulus (DAS) port array logic coupled to the plurality of logic arrays; and
enabling a control program to randomly access the plurality of logic arrays during run-time via a Direct Access Stimulus (DAS) interface coupling the control program to the set of DAS port array logic.
